# FASCICULE DE BREVET EUROPEEN

(11) **EP 3 140 910 B1**
(45) Date de publication et mention de la délivrance du brevet: **04.07.2018**
(21) Numéro de dépôt: 15723174.7
(22) Date de dépôt: 04.05.2015
(51) Int. Cl.: H03M 1/06, H03M 1/56, H03M 1/12

(54) **CONVERTISSEUR ANALOGIQUE-NUMÉRIQUE À RAMPE APTE À FOURNIR DIRECTEMENT UNE MOYENNE DE DEUX SIGNAUX**
ANALOG-DIGITAL-SLOPE-WANDLER ZUR DIREKTEN BEREITSTELLUNG VON DURCHSCHNITTLICH ZWEI SIGNALEN
RAMP ANALOG-DIGITAL CONVERTER ABLE TO PROVIDE AN AVERAGE OF TWO SIGNALS DIRECTLY

(30) Priorité: 05.05.2014 FR 1454062
(43) Date de publication de la demande: 15.03.2017
(73) Titulaire: Pyxalis, 38000 Grenoble (FR)
(72) Inventeur: SAINT MARTIN, Laurent, 38000 Grenoble (FR); CHENEBAUX, Grégoire, 38000 Grenoble (FR)
(74) Mandataire: Priori, Enrico
(86) Numéro de dépôt international: PCT/EP2015/059727
(87) Numéro de publication internationale: WO 2015/169755

(56) Documents cités:
- US-A1- 2009 021 411
- US-A1- 2009 066 554
- US-A1- 2009 309 991

## Description

L'invention concerne les convertisseurs analogiques-numériques à rampe, utilisés notamment, mais non exclusivement, dans des capteurs d'image matriciels pour fournir une valeur numérique représentative d'un niveau d'éclairement d'un pixel.

Les convertisseurs analogiques-numériques à rampe utilisent
- un comparateur recevant une tension de référence et une tension utile en vue de convertir la différence entre la tension utile et la tension de référence,
- une rampe de tension linéaire croissante ou décroissante, qui est superposée à l'une des tensions à partir d'un instant donné,
- un compteur numérique qui compte des impulsions à cadence fixe à partir du début de la rampe ;
- une mémoire qui conserve le contenu atteint par le compteur à l'instant où l'état de sortie du comparateur bascule du fait de la variation de tension engendrée par la rampe et appliquée au comparateur.

Le contenu du compteur est une représentation numérique de la différence entre la tension utile et la tension de référence.

Dans un capteur d'image, la tension de référence peut être une tension échantillonnée sur un conducteur de colonne après une opération de réinitialisation d'un pixel, et la tension utile est la tension échantillonnée sur ce même conducteur de colonne dans une opération de lecture des charges engendrées dans le pixel par l'éclairement.

Pour différentes raisons sur lesquelles on reviendra plus loin, on peut avoir besoin de convertir deux tensions utiles et de faire la moyenne des résultats de la conversion. Pour donner un exemple rapide, on peut vouloir convertir simultanément les signaux issus de deux pixels voisins dans un capteur matriciel et obtenir la moyenne des résultats ; on regroupe les valeurs données par deux pixels voisins lorsqu'il n'y a pas beaucoup de lumière et qu'on accepte de perdre en résolution d'image. Dans un autre exemple, on peut vouloir réduire les bruits de lecture des pixels en prenant deux échantillons successifs de la tension à convertir, en convertissant ces deux tensions et en faisant la moyenne des résultats de la conversion.

Dans ces deux exemples, la solution consiste à faire deux conversions analogiques-numériques (simultanées ou non) et à faire une addition numérique des résultats des deux conversions. Cependant, cette solution nécessite un traitement de valeurs numériques qui est lourd et encombrant dans un circuit intégré, par exemple lorsqu'il faut effectuer ce traitement sur des centaines de colonnes d'une matrice. Les documents US2009/0309991 A1, US2009/0066554 A1 et US2009/0021411 A1 sont des exemples de solutions connues dans l'état de la technique.

Pour permettre de faire une moyenne de deux mesures de manière plus simple, l'invention propose un procédé de conversion analogique-numérique utilisant un convertisseur à rampe, dans lequel
- on applique à un comparateur deux échantillons de tension dont l'un est additionné à une rampe de tension linéaire,
- on compte dans un compteur des impulsions à une fréquence F depuis un instant de début de la rampe jusqu'à un basculement du comparateur,
caractérisé en ce que :
- on applique à un deuxième comparateur deux autres échantillons de tension dont l'un est additionné à une rampe de tension linéaire d'instant de début et de pente identiques à la première rampe,
- on applique au compteur une fréquence de comptage moitié F/2 dès le basculement de l'un des deux comparateurs,
- et on mémorise le contenu du compteur au moment du basculement de l'autre comparateur.

Le contenu du compteur représente alors une moyenne numérique de deux différences de tension analogiques qui sont la différence entre les deux premiers échantillons de tension appliqués au premier comparateur et les deux autres échantillons de tension appliqués au deuxième comparateur.

Ce procédé est mis en oeuvre par un convertisseur analogique-numérique à rampe qui comporte un circuit établissant une rampe de tension, un compteur incrémenté par un signal d'horloge à une fréquence F à partir d'un instant de début de la rampe, un comparateur pour comparer deux échantillons de tension dont l'un est additionné à la rampe, caractérisé en ce que le convertisseur comporte un deuxième comparateur pour comparer deux autres échantillons de tension dont l'un est additionné à une rampe identique à la première rampe, un circuit logique de sélection de fréquence de comptage du compteur, commandé par les comparateurs, pour sélectionner la fréquence F au début de la rampe et sélectionner une fréquence moitié F/2 dès le basculement d'un des comparateurs, et un moyen pour mémoriser le contenu du compteur au moment du basculement de l'autre comparateur.

Dans une première utilisation, les deux comparateurs reçoivent des échantillons d'une même différence de tensions à convertir, c'est-à-dire un premier couple d'échantillons des tensions dont la différence doit être convertie et un second couple d'échantillons de ces tensions. Le bruit de conversion est réduit par l'obtention d'une moyenne de deux conversions sans que cette moyenne nécessite deux conversions suivies d'une addition numérique. Les échantillons de la même différence de tensions à convertir peuvent être des échantillons pris au même instant ou des échantillons pris à deux instants différents, de préférence à deux instants très rapprochés.

Dans une deuxième utilisation, les deux comparateurs reçoivent des échantillons simultanés de deux différences de tension différentes (mais voisines) et le convertisseur fournit une valeur qui est la moyenne de ces deux différences.

Dans le cas d'un capteur d'image, les différences de tension à convertir sont fournies par des conducteurs de colonne (reliant les pixels d'une même colonne) fournissant successivement un potentiel représentant un niveau de réinitialisation du pixel (réinitialisation d'une photodiode ou d'un noeud de stockage de charges) et un potentiel représentant l'éclairement d'un pixel. Les différences de tension appliquées aux deux comparateurs proviennent alors soit d'un même conducteur de colonne (pour réduire l'influence de bruits de mesure) avec un double échantillonnage fait à quatre instants différents sur le conducteur de colonne, soit de deux conducteurs de colonne (de préférence immédiatement adjacents), avec des échantillonnages simultanés pour les deux colonnes, en vue de fournir une mesure de la moyenne des éclairement reçus par deux pixels.

De manière générale, dans cette description, on considère que le convertisseur convertit des échantillons de tension, étant entendu que l'un des échantillons de tension peut être indifféremment soit une tension fixe donnée par une source de référence sans qu'il soit besoin d'un échantillonneur, soit un échantillon de tension variable fourni par un échantillonneur bloqueur.

On peut généraliser l'invention dans le but de faire une moyenne de plus de deux mesures. Dans ce cas, l'invention propose un procédé de conversion analogique-numérique utilisant un convertisseur à rampe, dans lequel
- on applique à un comparateur deux échantillons de tension dont l'un est additionné à une rampe de tension linéaire,
- on compte dans un compteur des impulsions à une fréquence F depuis un instant de début de la rampe jusqu'à un basculement du comparateur,
caractérisé en ce que :
- on applique à N-1 autres comparateurs N-1 autres couples de deux échantillons de tension dont l'un est additionné à une rampe de tension linéaire d'instant de début et de pente identiques à la première rampe,
- on applique au compteur une fréquence de comptage F_{N-1} telle que F_{N-1} = F(N-1)/N dès le basculement d'un comparateur,
- on applique successivement au compteur des fréquences de comptage plus basses F(N-2)/N, puis F(N-3)/N, et ainsi de suite jusqu'à F/N au fur à chaque fois qu'un comparateur bascule,
- et on mémorise le contenu du compteur au moment du basculement du comparateur qui bascule en dernier.

Le contenu du compteur représente alors une moyenne numérique de N différences de tension analogiques qui sont les différences de tension entre les couples d'échantillons de tension appliqués aux N comparateurs.

Le convertisseur analogique-numérique selon l'invention comporte dans ce cas un circuit établissant une rampe de tension, un compteur incrémenté par un signal d'horloge à une fréquence F à partir d'un instant de début de la rampe, un comparateur pour comparer deux échantillons de tension dont l'un est additionné à la rampe, caractérisé en ce que le convertisseur comporte N-1 autres comparateurs pour comparer N-1 autres échantillons de tension dont l'un est additionné à une rampe identique à la première rampe, un circuit logique de sélection de fréquence de comptage du compteur, commandé par les comparateurs, pour sélectionner la fréquence F au début de la rampe et sélectionner successivement des fréquences plus basses au fur et à mesure du basculement des comparateurs, la fréquence sélectionnée étant F(N-j)/N lorsque j comparateurs ont basculé, et un moyen pour mémoriser le contenu du compteur au moment du basculement du dernier comparateur.

D'autres caractéristiques et avantages de l'invention apparaîtront à la lecture de la description détaillée qui suit et qui est faite en référence aux dessins annexés dans lesquels :
- la figure 1 représente le principe d'un convertisseur à rampe ;
- la figure 2 représente une organisation possible des convertisseurs à rampe dans un capteur d'image matriciel ;
- la figure 3 représente un schéma détaillé du convertisseur dans le cas d'une conversion de différences de tension fournies par un échantillonneur bloqueur double ;
- la figure 4 est un chronogramme temporel d'une conversion analogique-numérique ;
- la figure 5 est un chronogramme montrant l'incertitude de conversion liée au bruit présent sur les échantillons à convertir ;
- la figure 6 est un chronogramme expliquant le procédé de conversion selon l'invention permettant de réduire le bruit présent sur les échantillons ;
- la figure 7 représente un schéma du convertisseur selon l'invention ;
- la figure 8 représente un schéma du convertisseur permettant de fournir la moyenne de deux signaux correspondant à deux pixels voisins dans un capteur d'image matriciel ;
- la figure 9 représente un schéma du convertisseur permettant de fournir soit la moyenne de deux mesures soit les mesures individuelles.

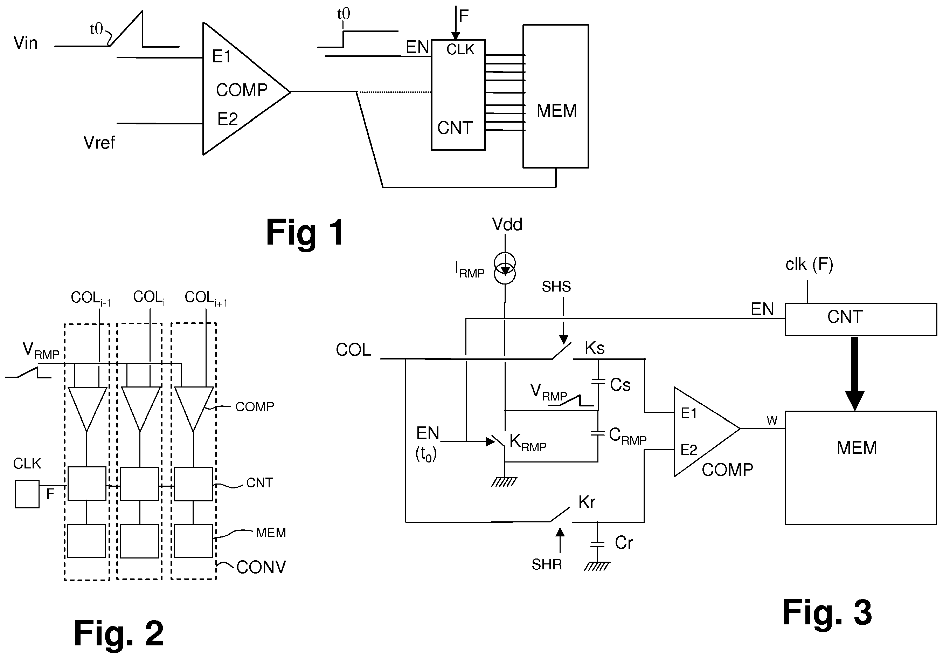

Sur la figure 1 on a représenté la structure générale d'un convertisseur analogique-numérique à rampe qui convertit en valeur numérique la différence entre une tension variable et une tension de référence.

Un comparateur de tension COMP à deux entrées E1, E2 reçoit sur ces entrées la tension variable Vin et la tension de référence Vref ; une rampe de tension linéaire croissante ou décroissante est ajoutée à l'une de ces deux tensions à partir d'un instant t0 qui définit le début de la conversion analogique-numérique. Le choix du sens de la rampe ou le choix de l'entrée à laquelle on applique la rampe est choisi en fonction du signe de la différence entre la tension variable et la tension de référence, ceci afin que les tensions appliquées aux deux entrées du comparateur deviennent égales au bout d'un temps variable qui définit la fin de la conversion. Ainsi, si la tension de référence est plus basse que la tension variable et si la rampe de tension est croissante, on est assuré que les tensions deviennent égales si on ajoute une rampe croissante à la tension de référence ou une rampe décroissante à la tension variable. Inversement, si la tension de référence est plus haute que la tension variable, il faut appliquer une rampe de tension décroissante à la tension de référence, ou alors ajouter une rampe croissante à la tension variable.

Ces solutions étant équivalentes, on considérera par convention dans la suite de la description de l'invention que la tension de référence est à un niveau systématiquement plus élevé que la tension variable, que la rampe est croissante et qu'elle est additionnée à la tension variable. C'est ce qui est représenté à la figure 1 pour un convertisseur classique. La tension sur l'entrée E1 croît à partir de Vin ; la tension sur l'entrée E2 reste à Vref pendant la conversion.

Un compteur CNT compte des impulsions appliquées à une entrée d'incrémentation qui reçoit ces impulsions à une fréquence d'horloge F. Le comptage est autorisé par un signal d'autorisation EN appliqué à une entrée d'autorisation du compteur. Ce signal démarre à l'instant t0 qui définit le début de la rampe de tension.

La sortie du comparateur bascule lorsque la tension sur l'entrée E1 atteint la valeur Vref du fait de la croissance de la rampe linéaire. Le basculement du comparateur déclenche alors la mémorisation du contenu du compteur, soit en arrêtant le comptage, soit en laissant le compteur continuer mais en déclenchant la mise en mémoire, dans une mémoire numérique MEM, du contenu du compteur à l'instant du basculement. Le compteur ou la mémoire contient alors une valeur représentative du temps (nombre de périodes d'horloge à fréquence F) mis pour égaliser les tensions sur les deux entrées du comparateur, donc représentative de la différence Vref-Vin dès lors que la rampe est linéaire.

La figure 2 représente schématiquement l'utilisation d'un tel convertisseur à rampe dans le contexte d'un capteur d'image matriciel comportant N lignes (N>=1) et P colonnes de pixels (P>1) non représentés. La lecture des pixels d'une ligne du capteur se fait ligne par ligne. La lecture d'une ligne se fait en parallèle pour les P pixels, à l'aide d'autant de convertisseurs analogiques-numériques qu'il y a de pixels dans la ligne. Chaque pixel de rang i d'une ligne en cours de lecture produit une tension qui est fonction de l'éclairement qu'il a reçu au cours d'une période d'intégration. Cette tension est appliquée à un conducteur de colonne respectif COLᵢ de rang i.

Les conducteurs de colonne de la matrice sont reliés chacun à l'entrée d'un convertisseur analogique-numérique à rampe respectif. Pour simplifier le schéma de la figure 2, on a considéré que le conducteur de colonne est relié à la première entrée du comparateur du convertisseur respectif, et qu'une rampe décroissante démarrant à une tension de référence Vref est appliquée à l'autre entrée. Cependant, on préférera le plus souvent appliquer à l'entrée du comparateur un échantillon de tension prélevé sur le conducteur de colonne et bloqué pendant le temps de la conversion. De même, il est possible de prévoir que la tension de référence Vref est un échantillon de tension prélevé et bloqué plutôt qu'une tension fixe.

Enfin, on a représenté sur la figure 2 une architecture dans laquelle une rampe de tension linéaire commune est fournie à tous les convertisseurs mais on pourrait avoir une rampe propre à chaque convertisseur. De même, on a considéré qu'il y a une seule horloge H définissant la fréquence de comptage mais il pourrait y avoir autant d'horloges (identiques) qu'il y a de convertisseurs. Les compteurs sont également propres à chaque convertisseur mais un compteur unique pourrait être prévu ; les mémoires reçoivent alors le contenu du compteur commun et mémorisent chacune le contenu au moment où elle en reçoit l'ordre.

La figure 3 représente plus en détail un exemple de convertisseur dans le contexte d'un capteur d'image fournissant une valeur numérique après chaque phase d'intégration de charges dans un pixel.

Le conducteur de colonne COL est relié à un circuit d'échantillonnage double qui prélève deux échantillons de tension sur ce conducteur.

Le premier échantillon Vr est une tension de réinitialisation du pixel. Cet échantillon est appliqué à une capacité d'échantillonnage Cr par la fermeture d'un interrupteur Kr à un moment où le conducteur de colonne reçoit du pixel un niveau de réinitialisation représentant une absence d'éclairement du pixel. Ce niveau est fourni par une photodiode ou un noeud de stockage temporaire de charges du pixel après que cette photodiode ou ce noeud aient été portés à un potentiel fixe de réinitialisation.

Le deuxième échantillon de tension Vs est un niveau de tension utile représentant l'éclairement du pixel. Il est appliqué à une autre capacité Cs par la fermeture d'un interrupteur Ks à un moment où le conducteur de colonne reçoit du pixel une tension représentant son éclairement. Ce niveau est fourni par la photodiode après un temps d'intégration, ou par le noeud de stockage temporaire de charges après que les charges d'une photodiode aient été transférées dans ce noeud.

Les échantillons de tension Vr et Vs sont bloqués et maintenus dans les capacités Cr et Cs par l'ouverture des interrupteurs respectifs Kr et Ks.

La capacité Cr est connectée entre l'entrée E2 du comparateur COMP et une masse à potentiel zéro. La capacité Cs est connectée entre l'entrée E1 du comparateur et la sortie d'un générateur de rampe de tension linéaire. Par exemple, le générateur produit une rampe V_{RMP} à partir de la charge d'une capacité C_{RMP} par une source de courant constant I_{RMP}. La capacité C_{RMP} est par exemple reliée à la masse. La sortie du générateur est prise au point de jonction de la capacité C_{RMP} et de la source de courant. La capacité C_{RMP} peut être court-circuitée par un interrupteur K_{RMP}. L'ouverture de cet interrupteur sous l'action d'un signal d'autorisation EN à un instant t₀ autorise la charge de la capacité C_{RMP} et fait monter linéairement le potentiel de l'entrée E1 du comparateur à partir de la tension qui a été échantillonnée dans la capacité Cs.

Le compteur reçoit un signal d'horloge clk à fréquence F. Le comptage est déclenché par le même signal d'autorisation EN qui sert à commander l'ouverture de l'interrupteur K_{RMP}, c'est-à-dire par le signal qui déclenche le début de la conversion analogique-numérique en démarrant la rampe.

La sortie du comparateur COMP bascule lorsque la tension VS+V_{RMP} sur l'entrée E1 atteint la valeur de la tension de référence Vr sur l'entrée E2. Le basculement déclenche la mémorisation du contenu du compteur dans la mémoire MEM. On notera qu'on peut dédoubler la mémoire pour accélérer le fonctionnement du capteur : chaque convertisseur possède deux mémoires, l'une pouvant être utilisée en lecture pendant que l'autre est utilisée en écriture et réciproquement ; le basculement du comparateur déclenche la mémorisation à chaque nouvelle conversion alternativement dans l'une des mémoires puis dans l'autre. Cette constitution avec deux mémoires n'est pas liée à la présente invention et ne sera pas décrite plus en détail.

On notera que dans certains cas, on pourrait prévoir qu'une tension fixe de référence est appliquée à l'entrée E2 à la place d'une tension échantillonnée provenant du conducteur de colonne.

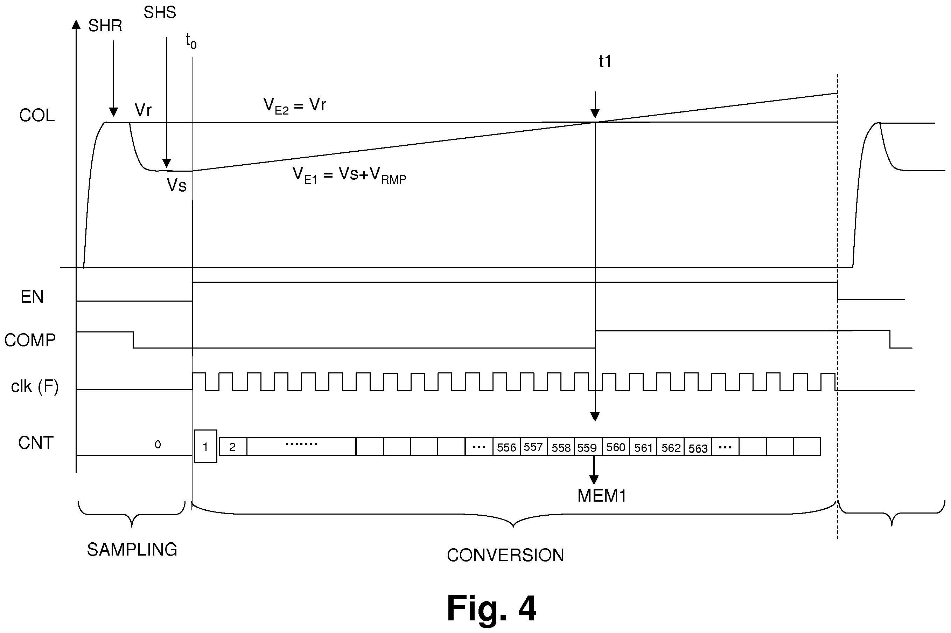

La figure 4 représente le chronogramme temporel d'une séquence de lecture et de conversion analogique-numérique pour un pixel d'un capteur d'image matriciel.

La sélection de la ligne contenant le pixel place une tension sur le conducteur de colonne. La tension est une tension Vr représentant un niveau de réinitialisation du pixel ou une tension utile Vs représentant l'éclairement selon le moment où on se place. On supposera ici que le niveau de réinitialisation et le niveau utile sont lus sur un noeud de stockage temporaire de charges du pixel, relié par l'intermédiaire d'un transistor de lecture du pixel au conducteur de colonne lors de la sélection de la ligne.

Dans l'exemple représenté à la figure 4, le niveau de réinitialisation Vr est lu avant le niveau utile Vs : on réinitialise le pixel puis on applique à l'interrupteur Kr un bref signal de commande de fermeture SHR pour échantillonner dans la capacité Cr le niveau de tension de réinitialisation Vr. Ce niveau Vr est conservé pendant toute la phase de conversion après réouverture de l'interrupteur Kr et il est appliqué à l'entrée E2 du comparateur COMP.

Le transfert de charges représentant l'éclairement, depuis la photodiode du pixel vers le noeud de stockage temporaire, cause une chute du potentiel du conducteur de colonne ; on applique alors à l'interrupteur Ks un bref signal SHS de commande de fermeture, ce qui échantillonne dans la capacité Cs le niveau de tension utile Vs représentant l'éclairement. La capacité Cs applique ce niveau de tension à l'entrée E1 du comparateur.

L'état de la sortie du comparateur est représenté sur la ligne COMP ; par convention on considère que c'est un état bas à l'instant t₀ de début de la rampe.

A l'instant t₀, on déclenche la rampe de tension linéaire croissante qui fait monter à partir de Vs le potentiel V_{E1} = VS+V_{RMP} de l'entrée E1.

On déclenche également à l'instant t₀ le comptage par le compteur CNT ; le comptage est incrémenté à la cadence donnée par une horloge à fréquence F. Des chiffres arbitraires sont indiqués sur la figure 4 pour représenter le contenu du compteur : ligne CNT.

A un instant t₁, lorsque la tension V_{E1} atteint la valeur Vr, le comparateur bascule et déclenche la mise en mémoire du contenu du compteur. Sur la figure 4, on voit que le contenu est égal à 559 au moment du basculement et c'est cette valeur qui est mise en mémoire.

Le comparateur est remis dans son état initial au début d'une séquence de lecture et conversion suivante ou bien il y revient naturellement au moment de l'échantillonnage du niveau de réinitialisation par le signal SHR.

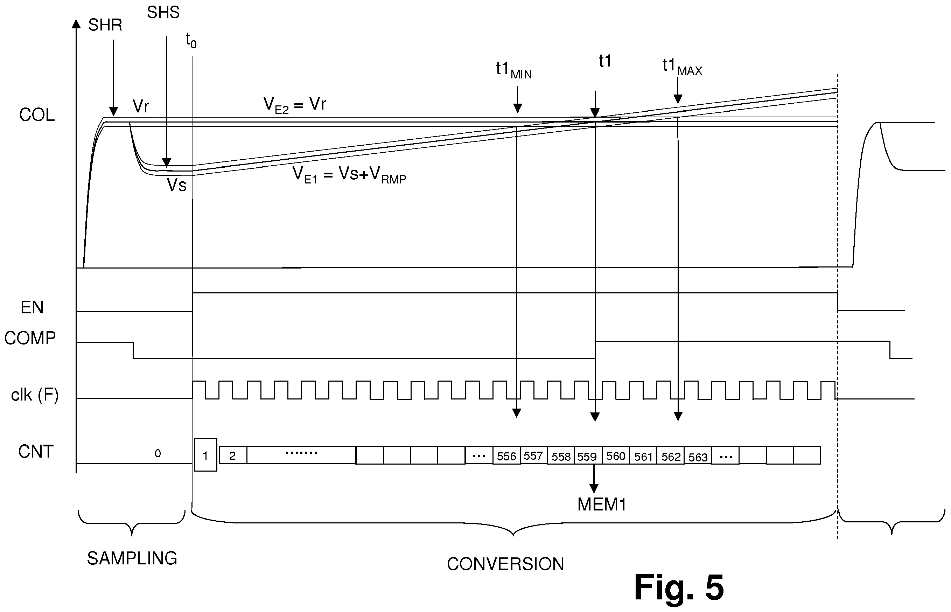

La figure 5 représente le même chronogramme que la figure 4, mais le niveau de tension à convertir est bruité, aussi bien en ce qui concerne le niveau Vr de réinitialisation que le niveau Vs utile. On a représenté ce bruit sous forme de courbes parallèles aux niveaux de la figure 4 mais de part et d'autre de ceux-ci. Autrement dit, le niveau Vr peut varier à l'intérieur d'une certaine plage de valeurs à cause du bruit, et le niveau Vs également, d'une manière indépendante du niveau Vr. Cela veut dire qu'on n'est pas sûr de l'instant exact de croisement des tensions sur les entrées E1 et E2 du comparateur lorsque l'entrée reçoit la tension VS+V_{RMP} croissant linéairement.

Pour une valeur théorique donnée Vr et une valeur théorique Vs, l'instant du croisement peut varier entre deux instants limites t1_{MIN} et t1_{MAX}.

Un croisement à l'instant t1_{MIN} se produit dans la configuration extrême où Vr est à un niveau réel au plus bas compte-tenu du bruit alors que Vs est à un niveau au plus haut compte-tenu du bruit. Inversement, un croisement à l'instant t1_{MAX} se produit dans la configuration extrême où Vr est à un niveau réel au plus haut compte-tenu du bruit alors que Vs est à un niveau au plus bas compte-tenu du bruit.

Le basculement du comparateur peut donc intervenir comme on le voit sur la figure 5 à des instants pour lesquels le contenu du compteur n'est pas le contenu théorique qu'il devrait contenir. Sur la figure 5, le contenu théorique du compteur au moment du basculement est 559, mais il est 556 à l'instant t1_{MIN} et 562 à l'instant t1_{MAX}.

Le bruit peut provenir de phénomènes en amont du convertisseur, mais aussi de l'offset du comparateur et d'autres sources de bruit à l'intérieur du convertisseur.

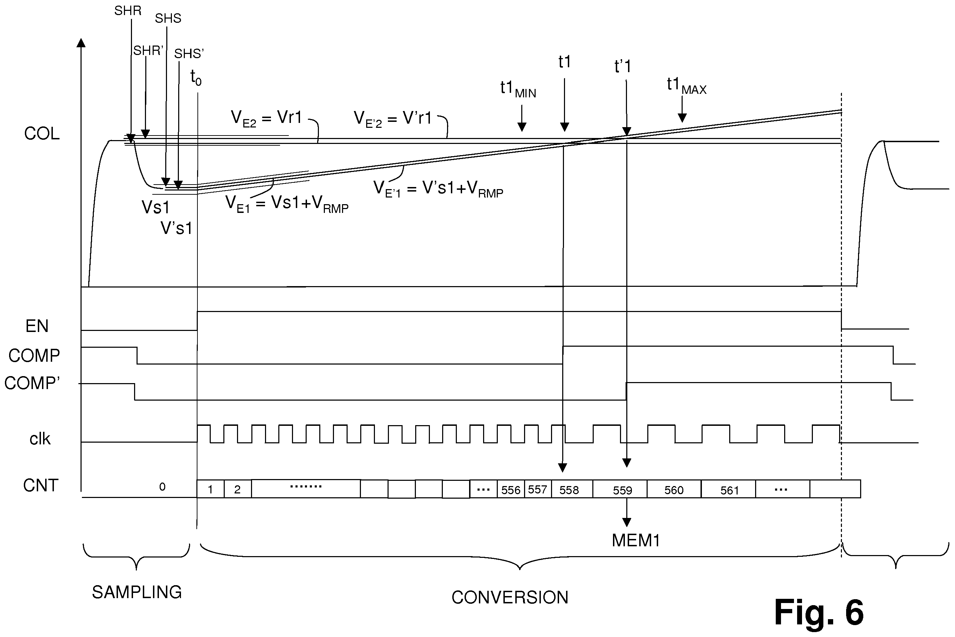

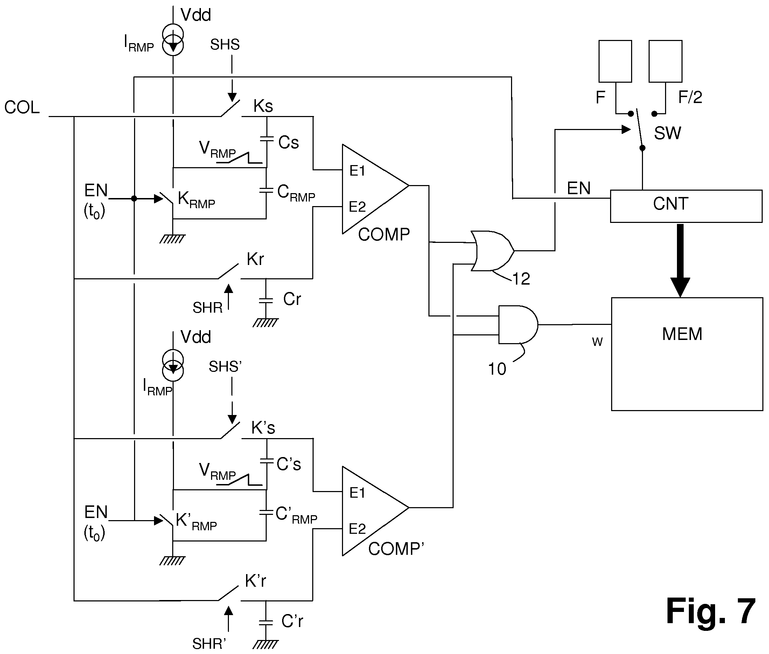

Pour minimiser l'effet de ce bruit, l'invention propose un procédé qu'on comprendra en se référant à la figure 6 pour le chronogramme et à la figure 7 pour la constitution du circuit de conversion.

Ce procédé consiste à utiliser deux échantillonneurs qui prélèvent chacun un couple d'échantillons de la même mesure, et deux comparateurs COMP et COMP', mais un seul compteur CNT pour compter une valeur qui représente la moyenne des deux différences d'échantillons, sans avoir besoin de convertir chacun des couples d'échantillons en vue de les additionner numériquement. Par couple d'échantillons, on entend ici l'échantillon Vr et l'échantillon Vs. Les quatre échantillons peuvent être pris à quatre instants différents. On considère ici qu'ils sont pris à quatre instants différents.

Les deux échantillonneurs sont identiques à celui de la figure 3 et leur fonctionnement ne sera pas décrit à nouveau. Ils comportent des capacités Cr, Cs et C'r, C's respectivement, des interrupteurs Kr, Ks et K'r, K's respectivement. Les échantillons pour Vr sont pris à deux instants proches définis par des commandes d'échantillonnage SHR et SHR' et sont dénommés Vr1 et V'r1, et de même pour les échantillons de Vs, pris à des instants SHS et SHS' et dénommés Vs1 et V's1. La même rampe linéaire V_{RMP} est appliquée aux capacités Cs et C's (ou en tous cas deux rampes identiques démarrant au même instant). Les éléments de circuit sont identiques en constitution et en valeurs numériques dans les deux échantillonneurs. Le signal d'autorisation EN est commun. Les tensions appliquées aux entrées du premier comparateur sont V_{E1} et V_{E2}. Celles qui sont appliquées au deuxième comparateur sont V'_{E1} et V'_{E2}.

Le croisement des courbes V_{E1} et V_{E2} sur la figure 5 donnerait un instant de basculement du premier comparateur à un instant t1 intermédiaire entre t1_{MIN} et t1 _{MAX}. De même le croisement des courbes V_{E1} et V_{E'2} pour le deuxième comparateur donne un basculement du deuxième comparateur à un instant t'1, également intermédiaire entre t1_{MIN} et t1_{MAX}. L'instant t1 peut se situer avant ou après l'instant t'1 selon que c'est le premier comparateur ou le deuxième comparateur qui bascule en premier.

Selon l'invention, dès qu'un comparateur bascule, que ce soit le premier ou le deuxième, on divise par deux la fréquence de comptage du compteur. On compte donc plus lentement. Dès que l'autre comparateur bascule, on relève le contenu du compteur, c'est-à-dire qu'on stocke dans la mémoire MEM le contenu du compteur.

Ce contenu est une moyenne des deux échantillonnages et cette moyenne est directement inscrite dans la mémoire, sans qu'il y ait besoin d'obtenir une valeur numérique pour le premier échantillon et une valeur numérique pour le deuxième. Cette moyenne réduit l'incertitude sur la mesure en présence de bruit.

Ainsi, dans l'exemple de la figure 5, on voit que le résultat de la conversion pourrait aller de 556 à 562 pour une valeur théorique de 559 si le signal n'était pas bruité. Dans l'exemple de la figure 6, le résultat de la conversion, donné par le basculement du comparateur qui bascule en second, est 559 en raison du comptage à fréquence F/2. Le basculement du premier comparateur en présence des échantillons Vr1 et Vs1 donne un résultat 558. Si le comptage s'était poursuivi à fréquence F comme à la figure 5, le basculement du deuxième comparateur en présence des échantillons V'r1 et V's1 aurait donné un résultat 560.

La figure 7 représente le schéma correspondant du circuit de conversion. Le signal à convertir est supposé là encore être un signal issu d'un conducteur de colonne COL d'un capteur d'image matriciel, sur lequel apparaît successivement un niveau de réinitialisation puis un niveau utile pour une mesure différentielle. Les sorties des comparateurs COMP et COMP' sont reliées à un petit circuit logique (une porte ET 10 et une porte OU 12) qui détermine quel comparateur bascule en premier et qui commande le stockage du contenu du compteur dans la mémoire à partir du basculement de l'autre comparateur.

Les sorties des comparateurs sont considérées comme actives au niveau logique haut après basculement. Elles sont reliées aux deux entrées de la porte OU 10. La sortie de la porte OU active un commutateur SW qui aiguille vers l'entrée de commande d'incrémentation du compteur soit une horloge à fréquence F (sortie de porte OU au niveau bas) soit une horloge à fréquence F/2 (sortie de porte OU au niveau haut). Initialement, la fréquence de comptage est F. Elle devient F/2 dès le basculement de l'un des comparateurs.

Par ailleurs les sorties des comparateurs sont reliées aux entrées de la porte ET. La sortie de la porte ET reste au niveau bas jusqu'à ce que les deux comparateurs aient basculé. Lorsqu'elle passe au niveau haut, elle commande le stockage du contenu du compteur dans la mémoire.

Ce principe de mesure directe de moyenne de deux signaux peut être généralisé à la mesure de la moyenne de N signaux où N est supérieur à 2. Par exemple, N peut aller de 3 à 10. Dans ce cas, on utilise N comparateurs et non pas deux. Chaque comparateur de rang i reçoit un couple d'échantillons respectif de rang i, Vᵢr, Vᵢs, parmi N couples pour lesquels on veut obtenir directement une valeur numérique de la moyenne des différences Vᵢr-Vᵢs. Les sorties des comparateurs sont reliées aux entrées d'un circuit logique plus complexe que celui de la figure 7, c'est-à-dire plus complexe qu'un simple couple de portes ET,OU. Ce circuit a pour fonction logique de déterminer le nombre j de comparateurs qui ont basculé à un instant donné et de commander en conséquence un circuit de sélection d'une fréquence parmi N fréquences possibles qui sont les fréquences F, (N-1)F/N, (N-2)F/N, etc... F/N. Le circuit logique sélectionne la fréquence F au départ de la conversion, c'est-à-dire au départ de la rampe linéaire, puis la fréquence F(N-j)/N si j comparateurs ont basculé, j variant de 1 à N-1 au fur et à mesure des basculements, et ceci quels que soient les comparateurs qui ont basculé. Si deux comparateurs basculent en même temps, on passe directement de la fréquence F(N-j+1)/N à la fréquence F(N-j-1)/N.

Le basculement du dernier comparateur déclenche la mémorisation du contenu du compteur, et ce contenu représente la moyenne des N signaux, c'est-à-dire la moyenne de N différences de tension Vᵢr-Vᵢs.

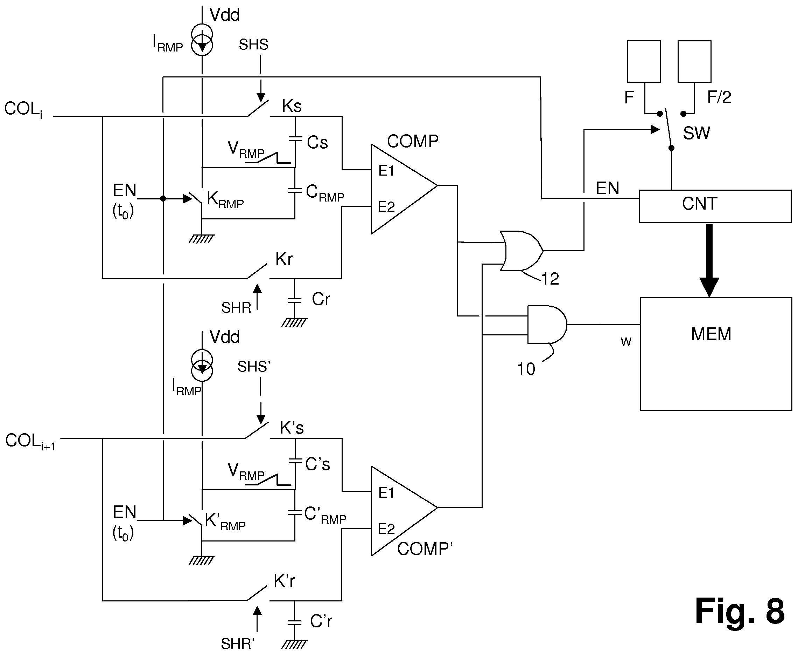

La figure 8 représente un schéma très semblable à celui de la figure 7 et les éléments communs ne seront pas re-décrits ; la différence avec la figure 7 est le fait que le circuit de conversion est destiné à fournir une valeur numérique de la moyenne de mesures de signaux différents mais voisins, alors que la figure 7 s'intéressait au même signal à des instants d'échantillonnage différents. Les signaux d'entrée sont donc différents mais les circuits associés aux comparateurs COMP et COMP' sont identiques et fonctionnent de la même manière.

Par exemple, dans une matrice de pixels, on souhaite regrouper en une seule valeur moyenne les mesures fournies par deux pixels adjacentes d'une même ligne de pixels. C'est le cas en particulier lorsqu'il y a peu de lumière et qu'on veut augmenter la sensibilité au détriment de la résolution.

Au moment de la sélection de la ligne, les deux pixels adjacents fournissent sur deux conducteurs de colonne adjacents COLᵢ et COLᵢ₊₁ des tensions de réinitialisation (Vrᵢ, Vsᵢ) puis des tensions utiles (Vrᵢ₊₁, VSᵢ₊₁) ; les tensions de réinitialisation sont échantillonnées par un signal commun SHR ; les tensions utiles sont échantillonnées par un signal SHS. Les signaux correspondant à la colonne de rang i sont appliqués à l'échantillonneur-bloqueur associé au comparateur COMP, et les signaux correspondant à la colonne de rang i+1 sont appliqués à l'échantillonneur-bloqueur associé au comparateur COMP'.

Selon la valeur des différences d'échantillons, c'est le comparateur COMP ou le comparateur COMP' qui bascule en premier au cours de la rampe commune. Le compteur qui comptait à la fréquence F compte à la fréquence F/2 à partir du basculement.

Lorsque l'autre comparateur bascule, le contenu du compteur est mis en mémoire. Il représente la moyenne des mesures des deux pixels (moyenne entre la différence VSᵢ - Vrᵢ des échantillons issus de la colonne de rang i et la différence VSᵢ₊₁ - Vrᵢ₊₁ des échantillons issus de la colonne de rang i+1).

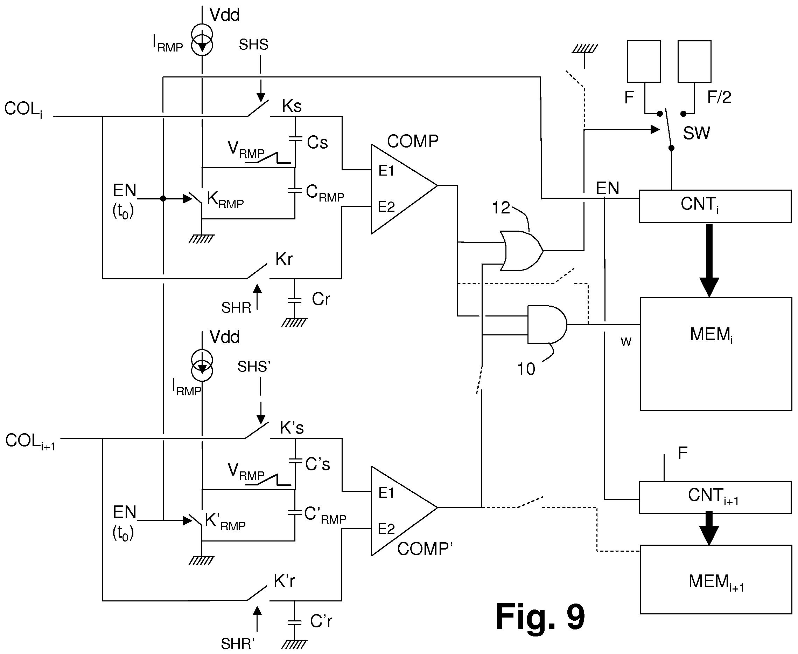

Si on veut que le circuit de la figure 8 puisse être utilisé soit en mode de moyennage de deux pixels adjacents soit en mode de lecture individuelle de chaque pixel, on peut modifier ce schéma comme indiqué sur la figure 9, sur laquelle on a rajouté un compteur CNTᵢ₊₁ (comptage à fréquence F) et une mémoire MEMᵢ₊₁ pour la conversion individuelle des signaux de la colonne COLᵢ₊₁, et un groupe de plusieurs commutateurs représentés en traits tiretés, qui permettent de passer du mode moyennage de la figure 8 à un mode de lecture individuelle des colonnes :
- commutateur qui relie la sortie du comparateur COMP' à la mémoire MEMᵢ₊₁ pour que celle-ci puisse enregistrer la mesure de la colonne de rang i+1,
- commutateur qui fige à zéro la sortie de la porte OU, pour qu'il n'y ait plus de changement de fréquence de comptage;
- commutateur qui court-circuite la porte ET pour relier la sortie du comparateur COMP à la mémoire MEMᵢ, de sorte que seul le basculement du comparateur COMP agit sur la mémoire MEMᵢ
- éventuellement un commutateur qui déconnecte la sortie du comparateur COMP' des portes OU et ET servant au moyennage, pour cesser d'effectuer le moyennage,

L'agencement de ces commutateurs n'est donné qu'à titre d'exemple, pour faire comprendre le changement de mode, bien d'autres circuits logiques d'aiguillage pouvant être imaginés.

## Revendications

1. Procédé de conversion analogique-numérique utilisant un convertisseur à rampe, dans lequel :
- on applique à un comparateur (COMP) un couple de deux échantillons de tension (Vr1, Vs1) dont l'un (Vs1) est additionné à une rampe de tension linéaire,
- on compte dans un compteur (CNT) des impulsions à une fréquence F depuis un instant de début de la rampe jusqu'à un basculement du comparateur,
**caractérisé en ce que** :
- on applique à N-1 autres comparateurs (COMP') N-1 autres couples de deux échantillons de tension (V'r1, V's1) dont l'un (V's1) est additionné à une rampe de tension linéaire d'instant de début et de pente identiques à la première rampe, N étant un entier positif,
- on applique au compteur une fréquence de comptage F_{N-1} telle que F_{N-1} = F(N-1)/N dès le basculement d'un comparateur,
- si N est supérieur à 2, on applique successivement au compteur des fréquences de comptage plus basses F(N-2)/N, puis F(N-3)/N, et ainsi de suite jusqu'à F/N à chaque fois qu'un comparateur bascule,
- et on mémorise le contenu du compteur au moment du basculement du comparateur qui bascule en dernier.

2. Procédé de conversion selon la revendication 1, **caractérisé en ce que** N=2.

3. Procédé de conversion selon l'une des revendications précédentes, **caractérisé en ce que** les comparateurs reçoivent des échantillons d'une même différence de tensions à convertir, dans le but de réduire le bruit de lecture.

4. Procédé de conversion selon la revendication 3, **caractérisé en ce que** tous lesdits échantillons sont pris à des instants différents.

5. Procédé de conversion selon l'une des revendications 1, ou 2, **caractérisé en ce que** les N comparateurs reçoivent des échantillons simultanés de N différences de tension différentes et le convertisseur fournit une valeur qui est la moyenne de ces N différences.

6. Convertisseur analogique-numérique à rampe qui comporte un circuit établissant une rampe de tension, un compteur (CNT) incrémenté par un signal d'horloge à une fréquence F à partir d'un instant de début de la rampe, un comparateur (COMP) pour comparer deux échantillons de tension est additionné à la rampe, **caractérisé en ce que** le convertisseur comporte N-1 autres comparateurs (COMP') pour comparer N-1 autres échantillons de tension dont l'un est additionné à une rampe identique à la première rampe, un circuit logique de sélection de fréquence de comptage du compteur, commandé par les comparateurs, pour sélectionner la fréquence F au début de la rampe et sélectionner successivement des fréquences plus basses au fur et à mesure du basculement des comparateurs, la fréquence sélectionnée étant F(N-j)/N lorsque j comparateurs ont basculé, et un moyen (MEM) pour mémoriser le contenu du compteur au moment du basculement du dernier comparateur, N étant un entier positif.

7. Convertisseur analogique-numérique à rampe selon la revendication 6, **caractérisé en ce que** N=2.

8. Capteur d'image matriciel utilisant un convertisseur selon l'une des revendications 6 ou 7, **caractérisé en ce que** les 2N échantillons de tension sont fournis par un conducteur de colonne (COL) reliant les pixels d'une même colonne de pixels, les échantillons étant pris à 2N instants différents.

9. Capteur d'image matriciel utilisant un convertisseur selon la revendication 8, **caractérisé en ce que** lesdites couples d'échantillons de tension sont fournis par des conducteurs de colonne respectifs (COLᵢ, COLᵢ₊₁), reliant chacun les pixels d'une même colonne de pixels.

## Patentansprüche

1. Analog-Digital-Wandlungsverfahren, verwendend einen Rampenwandler, bei welchem:
- man an einen Komparator (COMP) ein Paar von zwei Spannungs-Abtastsignalen (Vr1, Vs1) anlegt, wovon eines (Vs1) zu einer linearen Spannungsrampe hinzuaddiert wird,
- man in einem Zähler (CNT) Impulse einer Frequenz F von einem Anfangszeitpunkt der Rampe bis zum Kippen des Komparators zählt,
**dadurch gekennzeichnet, dass**:
- man an N-1 andere Komparatoren (COMP') N-1 andere Paare von zwei Spannungs-Abtastsignalen (V'r1, Vs1) anlegt, wovon eines (V's1) zu einer linearen Spannungsrampe mit identischem Anfangszeitpunkt und identischer Steigung wie die erste Rampe hinzuaddiert wird, wobei N eine positive Ganzzahl ist,
- man an den Zähler eine Zählfrequenz F_{N-1} anlegt, die so beschaffen ist, dass F_{N}-1 = F(N-1)/N, sobald ein Komparator kippt,
- wenn N größer als 2 ist, man nacheinander niedrigere Zählfrequenzen F(N-2)/N, gefolgt von F(N-3)/N an den Zähler anlegt und so weiter bis F/N, jedes Mal, wenn ein Komparator kippt,
- und man den Inhalt des Zählers zum Zeitpunkt des Kippens des Komparators, der als letzter kippt, speichert.

2. Wandlungsverfahren nach Anspruch 1, **dadurch gekennzeichnet, dass** N=2 ist.

3. Wandlungsverfahren nach einem der vorhergehenden Ansprüche, **dadurch gekennzeichnet, dass** die Komparatoren Abtastsignale mit einer gleichen Spannungsdifferenz zum Wandeln erhalten, um das Lesegeräusch zu reduzieren.

4. Wandlungsverfahren nach Anspruch 3, **dadurch gekennzeichnet, dass** alle solche Abtastsignale zu unterschiedlichen Zeitpunkten abgenommen werden.

5. Wandlungsverfahren nach einem der Ansprüche 1 oder 2, **dadurch gekennzeichnet, dass** die N Komparatoren gleichzeitige Abtastsignale von N unterschiedlichen Spannungsdifferenzen erhalten und der Wandler einen Wert bereitstellt, der den Durchschnitt dieser N Differenzen bildet.

6. Analog-Digital-Rampenwandler, beinhaltend eine Schaltung, welche eine Spannungsrampe etabliert, einen Zähler (CNT), der durch ein Uhrsignal mit einer Frequenz F ab dem Anfangszeitpunkt der Rampe inkrementiert wird, einen Komparator (COMP) zum Vergleichen zweier Spannungs-Abtastsignale der zur Rampe hinzuaddiert wird, **dadurch gekennzeichnet, dass** der Wandler N-1 andere Komparatoren (COMP') zum Vergleichen von N-1 anderen Spannungs-Abtastsignalen beinhaltet, wovon eines zur einer Rampe hinzuaddiert wird, die mit ersten Rampe identisch ist, eine logische Schaltung zur Zählfrequenzauswahl des Zählers, welche durch die Komparatoren gesteuert wird, zur Auswahl der Frequenz F zu Beginn der Rampe und zur sukzessiven Auswahl der niedrigeren Frequenzen im Zuge des Kippens der Komparatoren, wobei die ausgewählte Frequenz F(N-j)/N ist, wenn j Komparatoren gekippt sind, und ein Mittel (MEM) zum Speichern des Inhaltes des Zählers zum Zeitpunkt des Kippens des Komparators, der als letzter kippt, wobei N eine positive Ganzzahl ist.

7. Analog-Digital-Rampenwandler nach Anspruch 6, **dadurch gekennzeichnet, dass** N=2 ist.

8. Matrix-Bildsensor, verwendend einen Wandler nach einem der Ansprüche 6 oder 7, **dadurch gekennzeichnet, dass** die 2N Spannungs-Abtastsignale durch einen Spaltenleiter (COL) bereitgestellt werden, der die Pixel einer selben Pixel-Spalte verbindet, wobei die Abtastsignale zu unterschiedlichen 2N Zeitpunkten abgenommen werden.

9. Matrix-Bildsensor, verwendend einen Wandler nach Anspruch 8, **dadurch gekennzeichnet, dass** die Spannungs-Abtastsignal-Paare von den jeweiligen Spaltenleitern (COLᵢ, COLᵢ₊₁) bereitgestellt werden, welche jeden der Pixel einer selben Pixel-Spalte verbinden.

## Claims

1. An analog-digital conversion method using a ramp converter, in which:
- a pair comprising two voltage samples (Vr1, Vs1), one (Vs1) of which is added to a linear voltage ramp, is applied to a comparator (COMP),
- a counter (CNT) is used to count pulses at a frequency F from a starting instant of the ramp up until a toggling of the comparator,
**characterized in that**:
- N-1 other pairs of two voltage samples (V'r1, V's1), one (V'r1) of which is added to a linear voltage ramp with a starting instant and slope that are identical to those of the first ramp, are applied to N-1 other comparators (COMP'), N being a positive integer,
- a counting frequency F_{N-1} is applied to the counter so that F_{N-1} = F(N-1)/N from the toggling of a comparator,
- if N is greater than 2, lower counting frequencies F(N-2)/N, then F(N-3)/N, and so on up to F/N are successively applied to the counter each time a comparator toggles,
- and the content of the counter at the moment of toggling of the comparator that toggles last is stored.

2. The conversion method according to Claim 1, **characterized in that** N = 2.

3. The conversion method according to either of the preceding claims, **characterized in that** the comparators receive samples of one and the same voltage difference to be converted, with the aim of reducing reading noise.

4. The conversion method according to Claim 3, **characterized in that** all said samples are taken at different instants.

5. The conversion method according to either of Claims 1 and 2, **characterized in that** the N comparators receive simultaneous samples of N different voltage differences and the converter provides a value that is the average of these N differences.

6. A ramp analog-digital converter comprising a circuit setting up a voltage ramp, a counter (CNT) incremented by a clock signal at a frequency F from a starting instant of the ramp, a comparator (COMP) for comparing two voltage samples is added to the ramp, **characterized in that** the converter comprises N-1 other comparators (COMP') for comparing N-1 other voltage samples, one of which is added to a ramp that is identical to the first ramp, a logic circuit for selecting a counting frequency for the counter, controlled by the comparators, in order to select the frequency F at the start of the ramp and to successively select lower frequencies in step with the toggling of the comparators, the selected frequency being F(N-j)/N when j comparators have toggled, and a means (MEM) for storing the content of the counter at the moment of toggling of the last comparator, N being a positive integer.

7. The ramp analog-digital converter according to Claim 6, **characterized in that** N = 2.

8. A matrix image sensor using a converter according to either of Claims 6 and 7, **characterized in that** the 2N voltage samples are provided by a column conductor (COL) connecting the pixels of one and the same pixel column, the samples being taken at 2N different instants.

9. The matrix image sensor using a converter according to Claim 8, **characterized in that** said pairs of voltage samples are provided by respective column conductors (COLᵢ, COLᵢ₊₁), each connecting the pixels of one and the same pixel column.
